# EUROPÄISCHE PATENTANMELDUNG

(11) **EP 4 693 226 A1**
(43) Veröffentlichungstag der Anmeldung: **11.02.2026**
(21) Anmeldenummer: 24193502.2
(22) Anmeldetag: 08.08.2024
(51) Int. Cl.: G06V 20/70, G06V 10/82

(54) **DEMONTAGEUNTERSTÜTZUNGSVERFAHREN UND DEMONTAGEUNTERSTÜTZUNGSANORDNUNG**

(71) Anmelder: Siemens Aktiengesellschaft, 80333 München (DE)
(72) Erfinder: POL, Sebatian, 90763 Fürth (DE); KRUBASIK, Edward Cornelius, 80809 München (DE); GEIPEL, Markus Michael, 81739 München (DE); SEILER, Fabian, 80805 München (DE); KORAA, Omar Khaled Abdelmoniem Taha Mohamed, 80809 München (DE); RATH, Medhansh, 80809 München (DE); TOSUN, Kerim, 81243 München (DE); BALLIF, Pierre, 80805 München (DE); JOSHI, Shubham, 69115 Heidelberg (DE)
(74) Vertreter: Siemens Patent Attorneys

(57) **Zusammenfassung**

Die Erfindung betrifft ein Demontageunterstützungsverfahren, aufweisend folgende Schritte:
a) Visuelles Erfassen zumindest eines Teils eines zu demontierenden Produktes durch eine, insbesondere in einer AR-Brille integrierte, Bildaufnahmevorrichtung,
b) Erzeugen von Bilddaten zu einem Foto des Teils,
c) Aufforderung zur Eingabe eines Prompts für eine multimodale LLM durch ein LLM-Modul,
d) Übermitteln der Bilddaten an das LLM-Modul und Erzeugen des Prompts zumindest auf Grundlage der Bilddaten,
e) Generieren einer zumindest einen Demontageschritt enthaltenden Ausgabe durch die multimodale LLM zur Bildung von mit dem Demontageschritt zumindest korrelierenden Demontagedaten auf Grundlage des Prompts,
f) Übermitteln der Daten an ein, insbesondere AR-, Visualisierungsmodul,
g) Erzeugen von zumindest mit den Demontagedaten korrelierenden Visualisierungsdaten durch das Visualisierungsmodul,
h) Übermitteln der Visualisierungsdaten zu einer, insbesondere in der AR-Brille integrierten, Bilderzeugungseinrichtung,
i) Erzeugen eines Bildes auf Grundlage der Visualisierungsdaten,
j) Ausgabe zumindest des erzeugten Bildes durch die Bilderzeugungseinrichtung,
k) Erfassen eines zumindest mit dem Ende korrelierenden Triggersignals,
l) Wiederholung der vorhergehenden Schritte so lange bis ein Abbruchkriterium erreicht ist. Ferner betrifft die Erfindung eine Demontageunterstützungsanordnung zur Durchführung des Verfahrens.

## Beschreibung

Die Erfindung betrifft ein Demontageunterstützungsverfahren gemäß dem Gattungsbegriff des Anspruchs 1 sowie eine Demontageunterstützungsanordnung gemäß Gattungsbegriff des Anspruchs 10.

Es ist bekannt, dass die Demontage von Produkten ein unabdingbarer Prozess im Rahmen der beiden zentralen Module zur Umsetzung eines nachhaltigen Produktlebenszyklus, nämlich der routinemäßigen Wartung und den End-of-Life-Strategien, insbesondere der Wiederaufarbeitung, ist. Mitarbeiter in Reparaturzentren stehen regelmäßig vor der Herausforderung, dass ihnen häufig das Wissen über die korrekte Demontage oder Reparatur eines Produkts fehlt, insbesondere neue Mitarbeiter.

Dies ist unter anderem auf die Vielzahl an Produkten zurückzuführen, mit denen sie täglich konfrontiert sind, wobei stetig neue Produkte, mit denen sie noch keine Erfahrung haben, hinzukommen. Die Suche nach einer Reparaturanleitung - sofern vorhanden - und der Versuch, den üblicherweise mit Text und Bildern dokumentierten Schritten zu folgen, kann oft recht umständlich sein.

Ein bekannter Ansatz dieses Problem zu überwinden, besteht darin die so genannte "Augmented Reality" (AR) Technologie anzuwenden, um entweder die Arbeiter durch die Reparatur zu führen oder um Neuankömmlinge zu schulen. In der Regel ist die Implementierung einer dies bereitstellenden AR-App jedoch für die gesamte Demontagesequenz eines bestimmten Produkts fest codiert. Die Anpassung der Implementierung für ein neues Produkt ist damit sehr zeitaufwändig und wird meist aufgrund einer negativen Kosten-Nutzenbilanz nicht in Betracht gezogen.

Um dieser Situation zu begegnen, kann auch eine automatische Generierung von Demontagesequenzen für Produkte in Betracht gezogen werden, aber dies hängt immer stark von Vorinformationen wie beispielsweise einem für die AR-App notwendigen CAD-Modell ab, mit dem geometrische und Mobilitätsbeschränkungen extrahiert werden können. In der Regel sind diese Vorabinformationen aber nicht verfügbar. Darüber hinaus ist eine Verknüpfung der generierten Demontagesequenz mit einer ordnungsgemäßen Visualisierung in einer AR-App in der Regel nicht möglich.

Die der Erfindung zugrundeliegende Aufgabe ist es eine technische Lösung anzugeben, die die Nachteile des Standes der Technik überwindet, insbesondere einen Automatisierungsgrad bei Reparaturen zu verbessern.

Diese Aufgabe wird ausgehend von Demontageunterstützungsverfahren gemäß dem Gattungsbegriff des Anspruchs 1 durch dessen Merkmale sowie ausgehend von der Demontageunterstützungsanordnung gemäß Gattungsbegriff des Anspruch 10 durch dessen kennzeichnende Merkmale gelöst.

Sofern es in der nachfolgenden Beschreibung nicht anders angegeben ist, beziehen sich die Begriffe "durchführen", "umsetzen", "transformieren", "übertragen", "berechnen", "rechnergestützt", "rechnen", "feststellen", "generieren", "konfigurieren", "rekonstruieren", "ermitteln", "erfassen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "rechnergestützt" oder "computergestützt" kann im Zusammenhang mit der Erfindung beispielsweise eine Implementierung des Verfahrens verstanden werden, bei der insbesondere ein Prozessor mindestens einen Verfahrensschritt des Verfahrens ausführt.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Unter einem "Modul" kann im Zusammenhang mit der Erfindung beispielsweise mindestens ein Prozessor und/oder mindestens eine Speichereinheit zum Speichern von Programmbefehlen verstanden werden, welche physisch an einem Ort, beispielsweise einem Teil einer Leiterplatte, funktional zusammenwirkend verbunden sind. Beispielsweise ist der Prozessor speziell dazu eingerichtet, die Programmbefehle derart auszuführen, dass der Prozessor Funktionen ausführt, um das erfindungsgemäße Verfahren oder einen Schritt des erfindungsgemäßen Verfahrens zu implementieren oder realisieren.

Bei dem erfindungsgemäßen Demontageunterstützungsverfahren erfolgen folgende Schritte:
a) Visuelles Erfassen zumindest eines Teils eines zu demontierenden Produktes durch eine, insbesondere in einer AR-Brille integrierte, Bildaufnahmevorrichtung,
b) Erzeugen von Bilddaten zu einem Foto des Teils,
c) Aufforderung zur Eingabe eines Prompts für ein multimodales LLM durch ein LLM-Modul,
d) Übermitteln der Bilddaten an das LLM-Modul und Erzeugen des Prompts zumindest auf Grundlage der Bilddaten,
e) Generieren einer zumindest einen Demontageschritt enthaltenden Ausgabe durch das multimodale LLM zur Bildung von mit dem Demontageschritt zumindest korrelierenden Demontagedaten auf Grundlage des Prompts,
f) Übermitteln der Daten an ein, insbesondere AR-, Visualisierungsmodul,
g) Erzeugen von zumindest mit den Demontagedaten korrelierenden Visualisierungsdaten durch das Visualisierungsmodul,
h) Übermitteln der Visualisierungsdaten zu einer, insbesondere in der AR-Brille integrierten, Bilderzeugungseinrichtung,
i) Erzeugen eines Bildes auf Grundlage der Visualisierungsdaten,
j) Ausgabe zumindest des erzeugten Bildes durch die Bilderzeugungseinrichtung,
k) Erfassen eines zumindest mit dem Ende korrelierenden Triggersignals,
l) Wiederholung der vorhergehenden Schritte so lange bis ein Abbruchkriterium erreicht ist.

Das erfindungsgemäße Verfahren, welches insbesondere zumindest zum Teil computergestützt betrieben wird, verbessert bekannte Demontageunterstützungsverfahren, indem es nahezu anpassungsfrei und automatisiert für alle Demontageaufgaben nutzbar ist. Hierzu trägt bei, dass Demontageschritte erfasst und durch Prompten zumindest eines LLMs Vorhersagen über die nächsten Schritte erzeugt und auch automatisch visualisiert werden können. Es entfällt damit eine individuelle, vor allem manuelle, Einrichtung der Demontageunterstützung je, insbesondere neuer, Produktart und/oder -variante. Zudem beschleunigen sich damit auch die Prozessschritte des Demontageunterstützungsverfahrens, da die Daten im Wesentlichen selbstständig erhoben werden und die einzelnen Verfahrensschritte in einer Art zusammenwirken, dass die Visualisierungsdatenerzeugung und somit auch die Visualisierung schneller und präziser erfolgen kann.

Die erfindungsgemäße Demontageunterstützungsanordnung ist gekennzeichnet durch Mittel zur Durchführung des Verfahrens und/oder einer seiner Weiterbildungen, womit sie zur Implementierung und mutatis mutandis damit zur Realisierung der im Zusammenhang mit dem Demontageunterstützungsverfahren genannten Vorteile beiträgt.

Weitere vorteilhafte Ausgestaltungen und Weiterbildungen der Erfindung sind durch die Unteransprüche angegeben.

Gemäß einer Weiterbildung des erfindungsgemäßen Demontageunterstützungsverfahrens wird parallel zum Schritt j) eine natürlichsprachliche, mindestens den Demontageschritt beinhaltende, Anweisung ausgegeben. Dies kann alternativ oder ergänzend zu anderen Ausgabemethoden erfolgen, insbesondere zu einer visuellen Ausgabe ergänzend kann dieser Ausgabeweg besonders dann vorteilhaft sein, wenn komplexe und/oder mehrere Demontageschritte durchzuführen sind und dies, insbesondere allein, visuell schwer oder nicht darstellbar ist bzw. ein Betrachten einer komplexen Visualisierung die Aufmerksamkeit vom zu demontierenden Produkt nehmen würde, so dass der Demontagevorgang verlängert sowie die Gefahr von Beschädigungen durch Unachtsamkeit bestehen würde.

Alternativ oder ergänzend kann das erfindungsgemäße Demontageunterstützungsverfahren vorteilhafterweise derart weitergebildet werden, dass die Ausgabe der Anweisung als Textausgabe, insbesondere als Einblendung auf der AR-Brille, und/oder Audioausgabe auf einem, insbesondere in der AR-Brille integrierten Lautsprecher, erfolgt. Eine Ausgabe als Text ist vor Allem bei einfachen und/oder wenigen Demontageschritten besonders geeignet, um einerseits eindeutig den Demontageschritt zu beschreiben und andererseits die Aufmerksamkeit vom Produkt nicht zu sehr abzulenken. Wohingegen die Audioausgabe bei komplexeren und mehreren Demontageschritten in der Regel vorteilhafter ist, da die visuelle Aufmerksamkeit dann zu 100% auf dem Produkt liegen kann, weil die Anweisung einen anderen Sinneskanal nutzt.

Vorzugsweise wird das erfindungsgemäße Demontageunterstützungsverfahren gemäß einer Weiterbildung derart weitergebildet, dass das multimodale LLM auf Grundlage von, insbesondere als digitale Daten vorliegenden, Handbüchern, beispielsweise Reparaturhandbüchern, Produktontologien und/oder weiteren als ontologische Quellen nutzbaren Daten, zumindest zu einem ersten, insbesondere vor einer Erstanwendung des Demontageunterstützungsverfahrens gelegenen, Zeitpunkt trainiert wird. Hierdurch können beispielsweise so genannte Off the Shelf LLM Modelle, wie beispielsweise ChatGPT, die prinzipiell für die Erfindung nutzbar sind, einem so genannten Fine Tuning unterworfen werden und ermöglichen somit auf die für den Einsatz bestimmte Domäne abgestimmte und damit akkurate Voraussagen des LLMs.

Alternativ oder ergänzend kann das erfindungsgemäße Demontageunterstützungsverfahren derart weitergebildet sein, dass die Bilddaten einem Promptgenerierungsprozess derart zugeführt werden, dass der Promptgenerierungsprozess den Prompt nach Art des so genannten "Retrieval Augmented Generation", RAG, erzeugt. Mit diesem Ansatz kann eine LLM ebenfalls zu besseren Voraussagen gebracht werden, so dass diese Weiterbildung Off the Shelf LLM Modell Vorhersagen verbessert, aber auch bereits fine getunten LLMs zu einer noch höheren Präzision der Vorhersagen verhilft.

Wird das erfindungsgemäße Demontageunterstützungsverfahren derart weitergebildet, dass einem, insbesondere als generative Kl ausgebildeten, Visualisierungsmodell die Demontagedaten derart zugeführt werden, dass das Visualisierungsmodell die Visualisierungsdaten erzeugt, lassen sich auf die konkrete Domäne abgestimmte Visualisierungsprozesse ermöglichen, die hierdurch akkurat und zeitsparend umgesetzt werden können.

Dies kann durch eine bevorzugte Weiterbildung des erfindungsgemäßen Demontageunterstützungsverfahrens, bei dem das Visualisierungsmodul derart betrieben und mit einer, insbesondere auf Grundlage einer generativen künstlichen Intelligenz ausgebildeten, Objekterkennung derart funktional verbunden wird, dass die Objekterkennung auf das Foto angewandt wird und Erzeugung derart erfolgt, dass dem Visualisierungsmodell mit den erkannten Objekten zumindest korrelierende Daten zugeführt werden, weiter verbessert werden, da durch die Objekterkennung die Montageteile des Produkts detektiert und datentechnisch gekennzeichnet und somit auch für eine visuelle Hervorhebung entsprechend dem Demontageschritt hervorgehoben werden können.

Gemäß einer weiteren vorteilhaften Weiterbildung des erfindungsgemäßen Demontageunterstützungsverfahrens wird das Triggersignal durch Betätigen einer Eingabevorrichtung, wie beispielsweise Schalter, Tastatur, Mikrofon, kameragestützte Gestenerkennung und/oder andere Mensch Maschine Schnittstelleneinrichtungen, generiert. Hierdurch kann ein gesicherter Abschluss des aktuellen Demontageschrittes angezeigt werden, so dass damit auch der Start eines etwaigen weiteren Demontageschrittes gemäß dem erfindungsgemäßen Verfahren eingeleitet werden kann.

Alternativ oder ergänzend kann das erfindungsgemäße Demontageunterstützungsverfahren derart weitergebildet werden, dass das Triggersignal automatisch auf Grundlage einer, insbesondere durch künstliche Intelligenz, Kl, gestützten, Auswertung einer kameragestützten Erfassung des Demontageschritts generiert wird. Hierdurch ist eine Möglichkeit geschaffen, den Abschluss eines Demontageschrittes automatisch zu erfassen, so dass der Start des etwaigen weiteren Demontageschrittes automatisch eingeleitet werden kann. Dies spart zum einen Zeit, und zum anderen können die vorhandenen Erfassungsgeräte hierfür genutzt werden, und es wird das Reparaturpersonal davon entlastet eine Eingabe machen zu müssen, was unter Umständen den Demontagevorgang auch stören, zumindest jedoch verzögern kann.

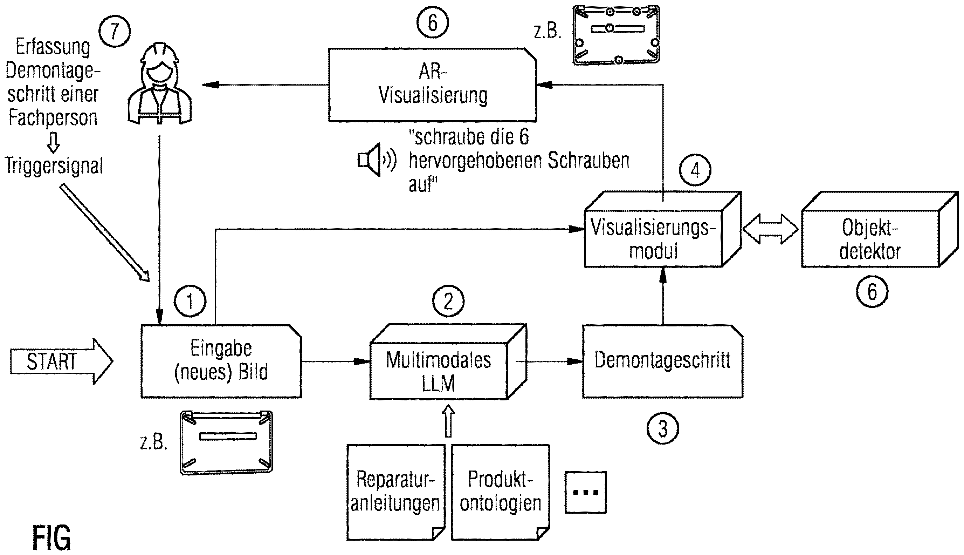

Im Folgenden werden weitere Vorteile und Details der Erfindung sowie Weiterbildungen der Erfindung anhand eines in der einzigen Figur dargestellten Ausführungsbeispiels näher erläutert. Es zeigt die
- Figur (FIG): schematisch einen beispielhaften Ablauf des Demontageunterstützungsverfahren in einer beispielhaften Demontageunterstützungsanordnung gemäß einem der möglichen Ausführungsbeispiele des erfindungsgemäßen Verfahrens sowie einem der möglichen Ausführungsbeispiele der erfindungsgemäßen Anordnung.

Bei dem im Folgenden in der Figur (FIG) erläuterten Ausführungsbeispiel handelt es sich um eine bevorzugte Ausführungsform anhand dessen Vorteile sowie weitere Ausführungsformen bzw. Weiterbildungen der Erfindung näher erläutert werden.

Insbesondere zeigen die nachfolgenden Erläuterungen lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis der unabhängigen Ansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Bei dem Ausführungsbeispiel bzw. den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

In der einzigen Figur FIG ist schematisch ein Ablauf eines ersten Ausführungsbeispiels des Verfahrens aber auch eines Ausführungsbeispiels der das Verfahren durchführenden Anordnung der Erfindung zu erkennen.

Bei dem dargestellten Ausführungsbeispiel ist zu erkennen, dass ausgehend von einem Startzeitpunkt START als ein erfindungsgemäßer Prozess ein iterativer Demontagezyklus ausgelöst wird.

Der Demontagezyklus beginnt in einem ersten Schritt 1 damit, dass ein Reparaturarbeiter ein zu demontierendes fertig montiertes Produkt visuell erfasst, was in der Darstellung als "Eingabe eines Bildes bezeichnet ist, und die visuelle Erfassung auf einer Bildausgabeeinrichtung wiedergegeben wird, das erfasste Bild zumindest jedoch an ein multimodales LLM-Modul weitergeleitet wird. Gemäß Ausführungsbeispiel erfolgt visuelle Erfassung durch eine AR-Brille, mit der der Reparaturarbeiter das Produkt betrachtet und den Prozess durch die Aufnahme eines Fotos auslöst, das auf einem Display und/oder über die AR-Brille visualisiert wird.

In einem zweiten Schritt 2 wird ein multimodales LLM-Modul, welches derart ausgestaltet ist, dass es Vision-Fähigkeiten einschließt, mindestens mit dem erfassten Bild als Eingangssignal für eine Eingabeaufforderung (Prompt) des multimodalen LLMs getriggert.

Das LLM ist gemäß Ausführungsbeispiel auf eine große Menge von Reparaturhandbüchern und Produktontologien abgestimmt und leitet darauf basierend einen sinnvollen ersten Demontageschritt in Textform ab, der in einem dritten Schritt 3 für das nächste Modul gemäß Ausführungsbeispiel vom LLM-Modul ausgegeben wird.

Alternativ oder ergänzend kann in diesem zweiten Schritt 2 (nicht dargestellt) über ein fein abgestimmtes Modell und/oder mit der so genannten "Retrieval Augmented Generation" Technologie (RAG) unter Nutzung von relevanten Informationen (z.B. ein Handbuch), die aus einer Datenbank abgerufen werden, um Kontext für die Eingabeaufforderung bereitzustellen, eine weitere Verbesserung der Vorhersage erreicht werden.

Darüber hinaus kann in einer weiteren Weiterbildung der Erfindung die Eingabeaufforderung im zweiten Schritt 2 durch nicht-textuelle Informationen wie beispielsweise einem CAD-Modell angereichert werden, wobei hierzu gemäß einer Weiterbildung über ein oder mehrere Schnittstellen/Kommunikationsverbindungen geprüft wird, ob so ein CAD-Modell verfügbar ist, um im Fall, dass dies so ist, zusätzliche Informationen wie beispielsweise geometrische und Mobilitätsbeschränkungen zu erhalten.

Der im dritten Schritt 3 am Ausgang des LLM-Moduls als Daten ausgegebene, durch das LLM abgeleitete textuelle Demontageschritt triggert in einem vierten Schritt 4 als Eingangssignal bzw. Eingangsdaten eines Visualisierungsmoduls ein Visualisierungsmodell, welches als Eingangsdaten das aufgenommene Bild mit dem generierten Demontageschritt kombiniert, um die Augmented-Reality-Visualisierung zu erstellen.

Die Kombination wird bei dem erfindungsgemäßen Beispiel dadurch erleichtert, dass das LLM einer bestimmten Ontologie folgt, wenn es darum geht, die Aufgabe zu beschreiben. Dies wird gemäß gezeigtem Ausführungsbeispiel weiterhin dadurch verbessert, dass Objekte, auf die sich die Aufgabe bezieht, beispielsweise wie dargestellt Schrauben, alternativ oder ergänzend in einem fünften Schritt 5 mit einem trainierten Objektdetektor, wie beispielsweise YOLOv8, im Bild erkannt und dort auch in einem sechsten Schritt 6 in einer für den Reparaturarbeiter erzeugten AR-Visualisierung, beispielsweise wie in der Figur dargestellt durch Umrandung derjenigen Schrauben, die aufgeschraubt werden sollen, visuell ausgegeben werden.

Alternativ oder ergänzend kann, wie im Ausführungsbeispiel auch angedeutet, diese Hervorhebung durch, beispielsweise auditive, Ausgabe einer Arbeitsanweisung, begleitet sein. Möglich ist auch alternativ oder ergänzend eine textuelle Einblendung der Arbeitsanweisung.

Mit dieser Ausgabe bzw. den Ausgaben ist nun der Reparaturarbeiter in der Lage, den in der AR-Anwendung gezeigten Demontageschritt physisch auszuführen, also real werden zu lassen. Dieser Vorgang kann automatisch erfasst werden, beispielsweise wieder durch die AR-Brille, und führt am Ende des aktuell durchgeführten Demontageschritts zur Aufnahme, die entweder im Rahmen des automatischen Erfassens oder durch Erfassen eines manuellen Auslösens getriggert wird, eines neuen Bildes im ersten Schritt 1, so dass damit ein weiterer Prozesszyklus getriggert wird, an dessen Ende eine neue Demontagevisualisierung steht, da das multimodale LLM auf der Grundlage des neuen Zustands (neues Bild) des Produkts auf einen nächsten Demontageschritt schließen kann.

Einer der Vorteile der erfindungsgemäßen Lösung besteht darin, dass sie automatisch die Demontage neuer Produkte unterstützen kann, ohne dass die Implementierung der erfindungsgemäßen Demontageunterstützungsanordnung und/oder des erfindungsgemäßen Demontageunterstützungsverfahrens angepasst werden muss.

Dies wird gemäß dem Ausführungsbeispiel unter anderem dadurch erreicht, dass die AR-Anwendung, die ein Reparaturarbeiter nutzt, um die erfindungsgemäße Demontageunterstützungsanordnung als ein Backend der AR-Anwendung, um unter anderem eine Schnittstelle zum multimodalen LLM herzustellen, zu erweitern, wobei die AR-Anwendung erfindungsgemäß Demontagesequenzen iterativ generiert und visualisiert.

Damit wird ermöglicht, dass die AR-Anwendung gemäß Ausführungsbeispiel sinnvolle Demontagesequenzen auch für noch nie dagewesene Produkte erzeugt und ferner funktionsreiche Anleitungen, wie beispielsweise gezielte Hervorhebung von Komponenten in der Ansicht des Benutzers, bietet, anstatt nur Textanweisungen anzuzeigen und das wie bereits hervorgehoben selbst für Produkte, die noch nie zuvor gesehen wurden.

*Unabhängig vom grammatikalischen Geschlecht eines bestimmten Begriffes sind Personen mit männlicher, weiblicher oder anderer Geschlechteridentität mit umfasst.*

## Patentansprüche

1. Demontageunterstützungsverfahren, aufweisend folgende Schritte:
a) Visuelles Erfassen zumindest eines Teils eines zu demontierenden Produktes durch eine, insbesondere in einer AR-Brille integrierte, Bildaufnahmevorrichtung,
b) Erzeugen von Bilddaten zu einem Foto des Teils,
c) Aufforderung zur Eingabe eines Prompts für eine multimodale LLM durch ein LLM-Modul,
d) Übermitteln der Bilddaten an das LLM-Modul und Erzeugen des Prompts zumindest auf Grundlage der Bilddaten,
e) Generieren einer zumindest einen Demontageschritt enthaltenden Ausgabe durch die multimodale LLM zur Bildung von mit dem Demontageschritt zumindest korrelierenden Demontagedaten auf Grundlage des Prompts,
f) Übermitteln der Daten an ein, insbesondere AR-, Visualisierungsmodul,
g) Erzeugen von zumindest mit den Demontagedaten korrelierenden Visualisierungsdaten durch das Visualisierungsmodul,
h) Übermitteln der Visualisierungsdaten zu einer, insbesondere in der AR-Brille integrierten, Bilderzeugungseinrichtung,
i) Erzeugen eines Bildes auf Grundlage der Visualisierungsdaten,
j) Ausgabe zumindest des erzeugten Bildes durch die Bilderzeugungseinrichtung,
k) Erfassen eines zumindest mit dem Ende korrelierenden Triggersignals,
l) Wiederholung der vorhergehenden Schritte so lange bis ein Abbruchkriterium erreicht ist.

2. Demontageunterstützungsverfahren nach dem vorhergehenden Anspruch,
**dadurch gekennzeichnet, dass** parallel zum Schritt j) eine natürlichsprachliche, mindestens den Demontageschritt beinhaltende Anweisung ausgegeben wird.

3. Demontageunterstützungsverfahren nach dem vorhergehenden Anspruch,
**dadurch gekennzeichnet, dass** die Ausgabe der Anweisung als Textausgabe, insbesondere als Einblendung auf der AR-Brille, und/oder Audioausgabe auf einem, insbesondere in der AR-Brille integrierten, Lautsprecher erfolgt.

4. Demontageunterstützungsverfahren nach einem der vorhergehenden Ansprüche,
**dadurch gekennzeichnet, dass** das multimodale LLM auf Grundlage von, insbesondere als digitale Daten vorliegenden, Handbüchern, beispielsweise Reparaturhandbüchern, Produktontologien und/oder weiteren als ontologische Quellen nutzbaren Daten, zumindest zu einem ersten, insbesondere vor einer Erstanwendung des Demontageunterstützungsverfahrens gelegenen, Zeitpunkt trainiert wird.

5. Demontageunterstützungsverfahren nach einem der vorhergehenden Ansprüche,
**dadurch gekennzeichnet, dass** die Bilddaten einem Promptgenerierungsprozess derart zugeführt werden, dass der Promptgenerierungsprozess den Prompt nach Art des so genannten "Retrieval Augmented Generation", RAG, erzeugt.

6. Demontageunterstützungsverfahren nach einem der vorhergehenden Verfahren,
**dadurch gekennzeichnet, dass** das Visualisierungsmodul derart betrieben wird, dass einem, insbesondere als generative KI ausgebildeten, Visualisierungsmodell die Demontagedaten derart zugeführt werden, dass das Visualisierungsmodell die Visualisierungsdaten erzeugt.

7. Demontageunterstützungsverfahren nach dem vorhergehenden Anspruch,
**dadurch gekennzeichnet, dass** das Visualisierungsmodul derart betrieben und mit einer, insbesondere auf Grundlage einer generativen künstlichen Intelligenz ausgebildeten, Objekterkennung derart funktional verbunden wird, dass die Objekterkennung auf das Foto angewandt wird und Erzeugung derart erfolgt, dass dem Visualisierungsmodell mit den erkannten Objekten zumindest korrelierende Daten zugeführt werden.

8. Demontageunterstützungsverfahren nach einem der vorhergehenden Ansprüche,
**dadurch gekennzeichnet, dass** das Triggersignal durch Betätigen einer Eingabevorrichtung, wie beispielsweise Schalter, Tastatur, Mikrofon, kameragestützte Gestenerkennung und/oder andere Mensch Maschine Schnittstelleneinrichtungen, generiert wird.

9. Demontageunterstützungsverfahren nach einem der vorhergehenden Ansprüche,
**dadurch gekennzeichnet, dass** das Triggersignal automatisch auf Grundlage einer, insbesondere durch künstliche Intelligenz, Kl, gestützten, Auswertung einer kameragestützten Erfassung des Demontageschritts generiert wird.

10. Demontageunterstützungsanordnung, **gekennzeichnet durch** Mittel zur Durchführung des Verfahrens nach einem der vorhergehenden Ansprüche.
